# EUROPEAN PATENT APPLICATION

(11) **EP 1 643 809 A1**
(43) Date of publication of application: **05.04.2006**
(21) Application number: 04723060.2
(22) Date of filing: 24.03.2004
(51) Int. Cl.: H05B 33/02, H05B 33/14, H05B 33/10

(54) **EL DEVICE, PROCESS FOR MANUFACTURING THE SAME, AND LIQUID CRYSTAL DISPLAY EMPLOYING EL DEVICE**

(30) Priority: 13.06.2003 JP 2003169502
(71) Applicant: KABUSHIKI KAISHA TOYOTA JIDOSHOKKI, Kariya-shi, Aichi-ken 448-8671 (JP)
(72) Inventor: FUNADA, Mari, Kabushiki Kaisha Toyota Jidoshokki, Kariya-shi, Aichi 4488671 (JP); KATO, Yoshifumi Kabushiki Kaisha Toyota Jidoshokki, Kariya-shi, Aichi 4488671 (JP); ITO, Hironori, Kabushiki Kaisha Toyota Jidoshokki, Kariya-shi, Aichi 4488671 (JP); TAKEUCHI, Norihito, K.K. Toyota Jidoshokki, Kariya-shi, Aichi 4488671 (JP); UTSUMI, Tetsuya DI, Deceased (JP)
(74) Representative: TBK-Patent
(86) International application number: PCT/JP2004/004132
(87) International publication number: WO 2004/112435

(57) **Abstract**

After entering a transparent substrate 9 of an organic EL device and passing through this substrate 9, an outside light L1 further passes through a transparent electrode 11 and an organic light emitting layer 12 to be reflected by a reflective electrode 13. Herein, the reflective electrode 13 has irregularities and therefore the outside light L1 is diffused and reflected by this at various angles. These reflected lights are further diffused when passing through a boundary between the organic light emitting layer 12 and the transparent electrode 11 and through an irregularity surface 10 of the transparent substrate 9, and outgo from the front surface of the transparent substrate 9 toward a liquid crystal panel. On the other hand, lights L2 to L4 emitted from the organic light emitting layer 12 are diffused when passing through the boundary between the organic light emitting layer 12 and the transparent electrode 11 and through the irregularity surface 10 of the transparent substrate 9, and outgo from the front surface of the transparent substrate 9 toward the liquid crystal panel.

## Description

### [Technical Field]

The present invention relates to an EL (electroluminescence) device, and more particularly to an EL device used for a backlight of a liquid crystal display device.

The present invention also relates to a method of manufacturing such an EL device and a liquid crystal display device using the EL device.

### [Background Art]

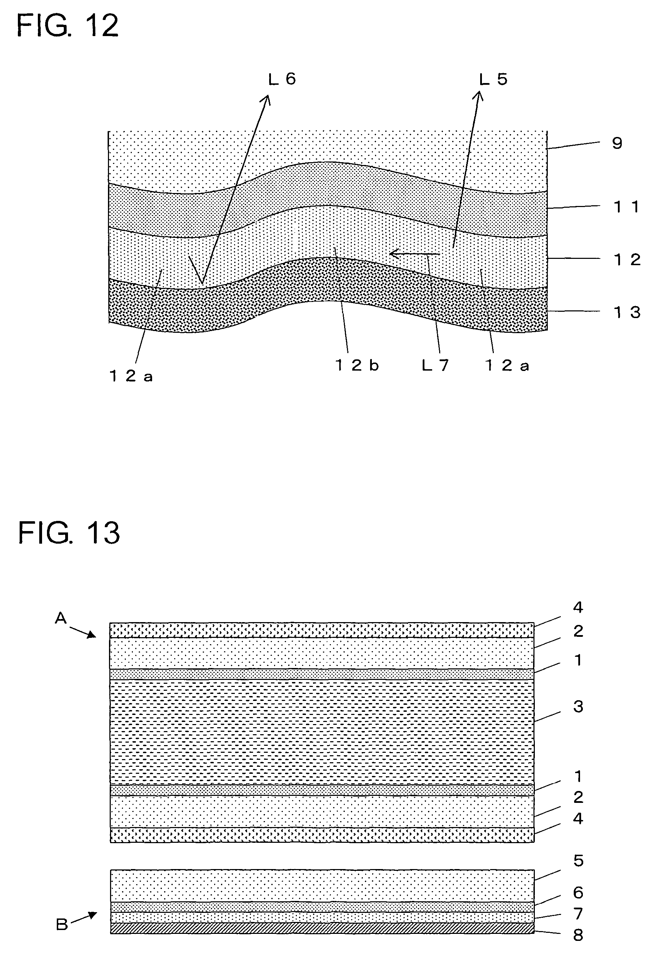

Heretofore, EL devices such as an inorganic EL device and an organic EL device have been used for displays and illumination devices. For example, among EL devices used for illumination devices, as shown in Fig. 13, there is an organic EL device B disposed at the rear of a liquid crystal panel A as a backlight and constituting a liquid crystal display device.

The liquid crystal panel A includes a pair of glass substrates 2 disposed in parallel and having transparent electrodes 1 on surfaces facing each other. Liquid crystal is sealed between the pair of glass substrates 2 to form a liquid crystal layer 3. Disposed on outer sides of the pair of glass substrates 2 are deflecting plates 4. Whereas the organic EL device B includes a transparent substrate 5. And, a transparent electrode 6, an organic light emitting layer 7, and a reflective electrode 8 are layered sequentially on the transparent substrate 5. Light emitted from the organic light emitting layer 7 of the organic EL device B passes through the transparent electrode 6 and the transparent substrate 5 as illumination light to enter the rear surface of the liquid crystal panel A from the organic EL device B, and display light in accordance with the orientation state of the liquid crystal layer 3 outgoes from the front surface of the liquid crystal panel A, whereby display is conducted.

In this liquid crystal display device, when the surrounding is dark as in a night time, the organic light emitting layer 7 of the organic EL device B is controlled to emit light for illumination. In contrast, in the case where the surrounding is sufficiently bright as in a day time, outside light is taken in from the front surface of the liquid crystal panel A to be reflected by the reflective electrode 8 of the organic EL device B, and this can be utilized as the illumination light.

However, in the liquid crystal display device described above, the reflective electrode 8 of the organic EL device B has a smooth surface, which reflects the incoming outside light like a mirror surface. Therefore, the intensity of the reflected light is increased in a certain direction in accordance with the direction of the outside light, the illumination becomes uneven, and the visual field angle of the liquid crystal panel A narrows.

In view of the above, for example, in a liquid crystal display device disclosed in JP 9-50031 A, a diffusion plate is arranged between the liquid crystal panel and the organic EL device. This diffusion plate allows uniform illumination and widening of the visual field angle of the liquid crystal panel through diffusion of the illumination light from the organic EL device.

However, when the diffusion plate is separately arranged between the liquid crystal panel and the organic EL device, the number of components increases, and the overall structure of the liquid crystal display device becomes complicated. In addition, there is a problem in that when the illumination light passes through the diffusion plate, the illumination light attenuates.

Further, the EL device is required to attain the following aspects.
· Luminance Enhancement (Light Emission Amount Increase, Light Taking-out Efficiency Improvement)
   In other words, it is required that the amount of light emission per unit area increase, or the amount of light to be taken out toward the outside of the device increase. It is because, in particular, with such an EL device of a bottom emission type as shown in Fig. 13 in which the light emitted from the light emitting layer outgoes through the substrate (transparent substrate) toward the outside, the amount of light capable of outgoing from the substrate toward the outside is limited.
· Directional Characteristics Improvement of Outgoing Light (Light Use Efficiency Improvement)
   In other words, the EL device is required to emit a light whose amount is increased in a certain direction. For example, the organic EL device B shown in Fig. 13 is required to emit a larger amount of light which enters the deflecting plates 4 of the liquid crystal panel A at an incident angle of 0°. This is because light which does not enter the liquid crystal panel A or which enters the liquid crystal panel A but does not outgo from the panel cannot be utilized for the liquid crystal display device.
· Chromaticity Characteristics Improvement Depending On Light Outgoing Direction
   In other words, it is required to provide an EL device having substantially no difference in chromaticity depending on light outgoing directions.

### [Disclosure of the Invention]

The present invention has beenmade in view of the above problems and requirements, a first object of the present invention is to provide an EL device capable of avoiding light attenuation due to the use of a diffusion plate and diffusing the light sufficiently to conduct uniform illumination while having a simple structure.

A second object of the present invention is to provide an EL device which attains a large light emission amount.

A third object of the present invention is to provide an EL device which attains high light taking-out efficiency.

A fourth object of the present invention is to provide an EL device which attains high luminance in a certain direction.

A fifth object of the present invention is to provide an EL device in which a difference in chromaticity depending on outgoing directions is small.

The present invention is also intended to provide a manufacturing method with which such an EL device can be obtained and a liquid crystal display device using such an EL device.

According to the present invention, there is provided an EL device, including: a substrate; a first electrode layer formed on a surface of the substrate; a light emitting layer formed on the first electrode layer; and a second electrode layer formed on the light emitting layer, the surface of the substrate having irregularities formed thereon, at least one of the layers formed on the surface of the substrate having irregularities formed on a surface thereof which is in contact with the layer on a side of the substrate.

The at least one of the layers can be formed in a substantially uniform thickness.

In addition, it is preferable that the at least one of the layers has a curved shape conforming to the surface of the substrate on which the irregularities are formed. When the at least one of the layers has such a curved shape, a layer formed on the layer may have irregularities. Examples of the curved shape include a shape which is substantially parallel to the irregularities on the surface of the substrate and has a uniform thickness, a shape having a concave portion formed thicker than a convex portion, and a shape having a convex portion formed thicker than a concave portion.

It is desirable that the light emitting layer has a curved shape conforming to the surface of the substrate on which the irregularities are formed.

It is preferable that, among the first electrode layer and the second electrode layer formed on both sides of the light emitting layer, one electrode layer opposite to a light taking-out side with respect to the light emitting layer is formed of a reflective electrode and the other electrode layer is formed of a transparent electrode, and that the reflective electrode has a curved shape conforming to the surface of the substrate on which the irregularities are formed.

In addition, it is desirable that the surface of the substrate on which the irregularities are formed is an irregularity surface on which a concave portion and a convex portion are formed at random.

It is preferable that at least one prism sheet is further disposed on a light taking-out side with respect to the light emitting layer. A sheet having a plurality of linear convex portions which are disposed in parallel to each other, and each of which is sharply pointed to have a triangular shape in cross section, can be used as the prism sheet. In this case, it is preferable that two prism sheets are overlapped and disposed so that extending directions of the linear convex portions intersect each other.

According to the present invention, there is provided a method of manufacturing an EL device, including: forming irregularities on a surface of a substrate; forming a first electrode layer on the surface of the substrate; forming a light emitting layer on a surface of the first electrode layer; and forming a second electrode layer on a surface of the light emitting layer, in which at least one of the layers formed on the surface of the substrate having irregularities formed on a surface thereof which is in contact with the layer on a side of the substrate.

In addition, one of the first electrode layer and the second electrode layer opposite to a light taking-out side with respect to the light emitting layer is formed of a reflective electrode and the other is formed of a transparent electrode, and the reflective electrode has a curved shape conforming to the surface of the substrate on which the irregularities are formed, whereby light is diffused and reflected by the surface of the reflective electrode.

Furthermore, it is desirable that the at least one of the layers includes the light emitting layer.

A liquid crystal display device according to the present invention uses the EL device according to the present invention for a backlight.

### [Brief Description of the Drawings]

Fig. 1 is a cross sectional view showing a structure of a liquid crystal display device according to Embodiment 1 of the present invention;
Fig. 2 is a diagram showing how light is reflected and diffused in an organic EL device in Embodiment 1;
Fig. 3 is a graph showing visual field angle characteristics of the organic EL device in Embodiment 1;
Fig. 4A and Fig. 4B, and Fig. 4C are cross sectional views showing, in a stepwise manner, a method of manufacturing the organic EL device in Embodiment 1, respectively;
Fig. 5 is a cross sectional view showing an organic EL device according to Embodiment 2 of the present invention;
Fig. 6 is an enlarged perspective view showing one prism sheet in Embodiment 2;
Fig. 7 is a cross sectional view showing an organic EL device according to a modification example of Embodiment 2;
Fig. 8 is an enlarged perspective view showing two prism sheets used in the modification example of Embodiment 2;
Fig. 9 is a graph showing a rate of increase in frontal luminance of the organic EL device in Embodiment 2;
Figs. 10 and 11 are each a graph showing the amount of the change in chromaticity coordinates x and y depending on the outgoing angle of the organic EL device in Embodiment 2;
Fig. 12 is a view showing a state of light emitted from a concave portion and a convex portion of an organic light emitting layer in Embodiment 1; and
Fig. 13 is a cross sectional view showing a structure of a conventional liquid crystal display device.

### [Best Mode for carrying out the Invention]

Hereinafter, embodiments of the present invention will be described with reference to the accompanying drawings.

### Embodiment 1

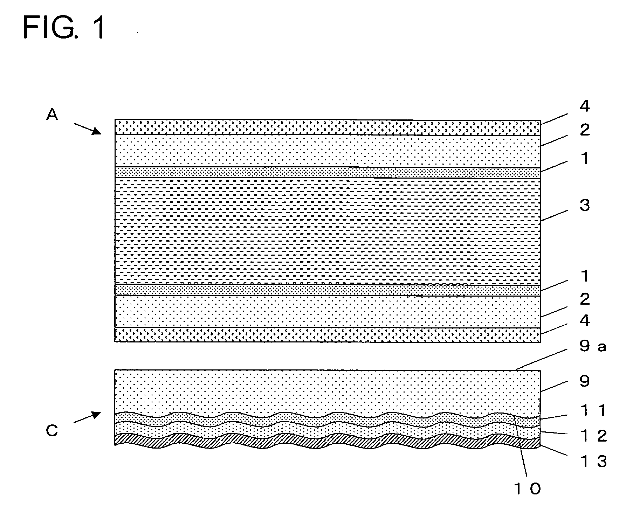

Fig. 1 shows a cross section of a liquid crystal display device according to Embodiment 1. This liquid crystal display device has a liquid crystal panel A and an organic EL device C disposed at the rear of the liquid crystal panel A as a backlight.
The liquid crystal panel A includes a pair of glass substrates 2 disposed in parallel and having transparent electrodes 1 on the surfaces facing each other. Liquid crystal is sealed between the pair of glass substrates 2 to form a liquid crystal layer 3. Further, disposed on outer sides of the pair of glass substrates 2 are deflecting plates 4.

On the other hand, the organic EL device C includes a transparent substrate 9, and this transparent substrate 9 has an irregularity surface 10 on which a concave portion and a convex portion are formed at random on a main surface of the substrate 9 opposite to the liquid crystal panel A. A transparent electrode 11 is formed on and along the irregularity surface 10 of this transparent substrate 9, an organic light emitting layer 12 is formed on and along the surface of the transparent electrode 11, and a reflective electrode 13 is further formed on and along the surface of the organic light emitting layer 12. For this reason, the transparent electrode 11, the organic light emitting layer 12, and the reflective electrode 13 each have irregularities. The transparent electrode 11, the organic light emitting layer 12, and the reflective electrode 13 each have a uniform thickness and therefore have a curved shape conforming to the irregularity surface 10 of the transparent substrate 9. The transparent electrode 11 and the reflective electrode 13 constitute a first electrode layer and a second electrode layer of the present invention, respectively. Note that, in this organic EL device C, a main surface of the transparent substrate 9 on the liquid crystal panel A side serves as a light outgoing surface 9a. In other words, the transparent electrode 11 and the transparent substrate 9 are disposed on the light taking-out side with respect to the organic light emitting layer 12 and have transparency to light (visible light, in general) taken out toward the outside of the EL device C, and the reflective electrode 13 is a layer on a side opposite to the light taking-out side with respect to the organic light emitting layer 12.

In this liquid crystal display device, the organic light emitting layer 12 of the organic EL device C is caused to emit light which is used as illumination light. Whereas in the case where the surrounding is sufficiently bright as in a day time, outside light passing through the liquid crystal panel A and entering the organic EL device C is reflected by the reflective electrode 13, and the resultant light can also be used as the illumination light. Those illumination lights enter the rear surface of the liquid crystal panel A, and display light in accordance with the orientation state of the liquid crystal layer 3 outgoes from the front surface of the liquid crystal panel A, thereby carrying out the display.

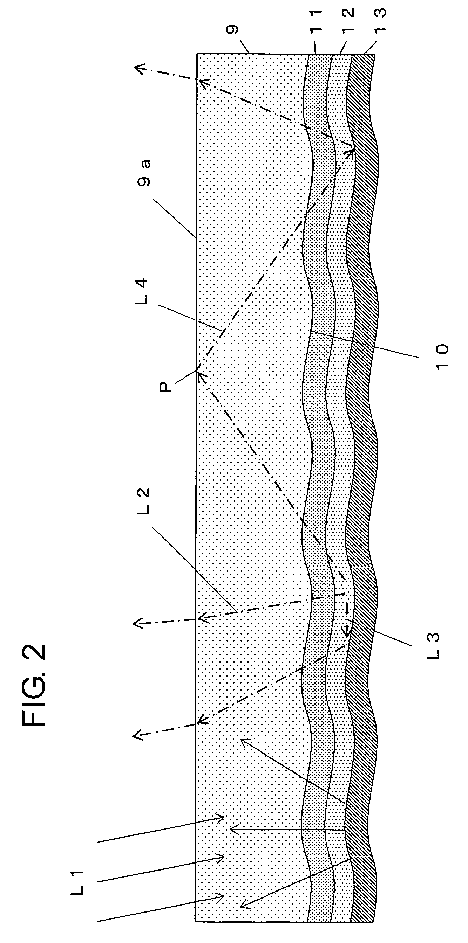

Herein, as shown in Fig. 2, outside lights L1 entering the transparent substrate 9 of the organic EL device C and passing through this substrate 9 then pass through the transparent electrode 11 and the organic light emitting layer 12 to be reflected by the reflective electrode 13. At this time, the outside lights L1 are diffused there and reflected at various angles because the reflective electrode 13 has a curved shape. When passing through the boundary between the organic light emitting layer 12 and the transparent electrode 11 and through the irregularity surface 10 of the transparent substrate 9, those reflected lights are further diffused owing to the refractive index difference, and the resultant lights outgo from the light outgoing surface 9a of the transparent substrate 9 toward the liquid crystal panel A. With this configuration, it is possible to obtain the uniform illumination light, and the conventional mirror reflection can be prevented. In addition, the diffused lights outgo from the front surface of the liquid crystal panel A at various angles, thereby making it possible to widely secure the visual field angle of the liquid crystal panel A.

Further, the reflective electrode 13 has a curved shape corresponding to the irregularity surface 10 so that a reflected image thereon is also diffused and reflected. Therefore, a double vision composed of an image displayed by the liquid crystal panel A and an image reflected on the reflective electrode, which is so-called double image formed as in the prior art, is hardly observed.

Hence, unlike in the prior art, it is unnecessary to arrange a diffusion plate independently, so attenuation of the outgoing light caused when the light passes through the diffusion plate can be eliminated.

On the other hand, when passing through the boundary between the organic light emitting layer 12 and the transparent electrode 11 and through the irregularity surface 10 of the transparent substrate 9, a light L2 emitted from the organic light emitting layer 12 of the organic EL device C is diffused owing to the refractive index difference, and the resultant light outgoes from the light outgoing surface 9a of the transparent substrate 9 toward the liquid crystal panel A. With this configuration, a part of the light which could not outgo from the inside of the layer toward the outside in a conventional flat light emitting layer can now be allowed to outgo therefrom.

In addition, since the organic light emitting layer 12 has a curved shape, among the lights emitted from the organic light emitting layer 12, a part of a light L3 emitted in substantially parallel with respect to the light outgoing surface 9a of the transparent substrate 9 is reflected by the reflective electrode 13, and the reflected light passes through the organic light emitting layer 12 and the transparent electrode 11 to outgo from the light outgoing surface 9a of the transparent substrate 9 toward the liquid crystal panel A.

Furthermore, among the lights emitted from the organic light emitting layer 12, a light L4 totally reflected at a point P of the light outgoing surface 9a of the transparent substrate 9 passes through the transparent electrode 11 and the organic light emitting layer 12 and reaches the reflective electrode 13 to be reflected by this reflective electrode 13. As the reflective electrode 13 has the irregularities, the angle with respect to the light outgoing surface 9a of the transparent substrate 9 varies at the time of the reflection. As a result, the light L4 totally reflected by the light outgoing surface 9a and returning to the inside of the organic EL device C is also likely to finally outgo from the light outgoing surface 9a of the transparent substrate 9 toward the liquid crystal panel A.

In this way, each of the reflected light of the light L3 emitted substantially in parallel with respect to the transparent substrate 9 and the reflected light of the light L4 totally reflected by the light outgoing surface 9a of the transparent substrate 9 can be utilized as the illumination light, whereby it is possible to provide an organic EL device with high light taking-out efficiency.

In addition, the irregularities formed on the transparent substrate 9, the transparent electrode 11, the organic light emitting layer 12, and the reflective electrode 13 are each allowed to have the light condensing function of a micro lens or the like by selecting the shape of the irregularities.

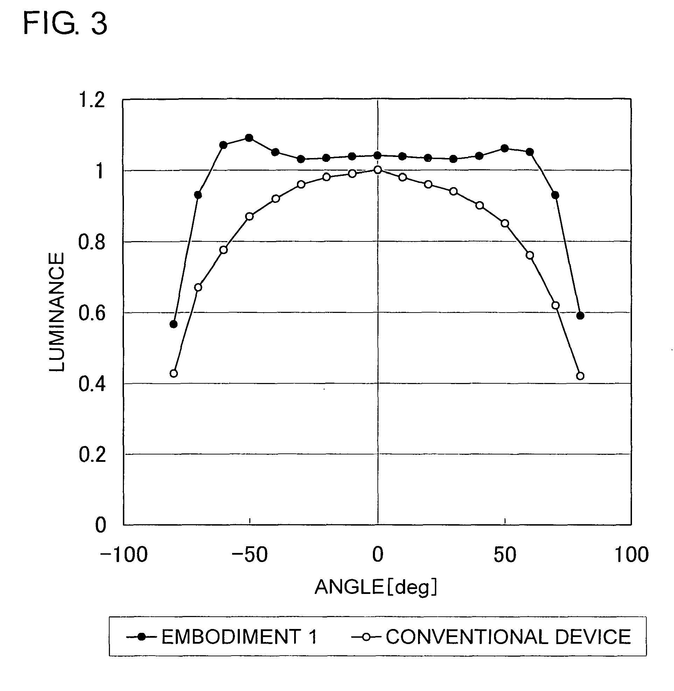

Fig. 3 shows the luminance characteristics with respect to the visual field angle upon light emission regarding the organic EL device C according to Embodiment 1 and the conventional organic EL device B shown in Fig. 13. In this graph, the luminance in the normal direction on the light outgoing surface of the conventional organic EL device B is set as the reference, in terms of ratio to this reference, the magnitude of luminance is represented. Further, each of the organic EL devices was manufactured with the same material, the same thickness, and the same manufacturing method, except that the substrate of the device C was provided with the irregularity surface and the substrate of the device B was made flat.

As is understood from this graph, the organic EL device C of Embodiment 1 has high luminance over the entirety of the wide visual field angle as compared to the conventional organic EL device B, and the visual field angle is widened. Among the lights emitted from the flat organic light emitting layer 7 of the conventional organic EL device B, the light entering the front surface of the transparent substrate 5, i.e., the light outgoing surface, at a critical angle or larger, is repeatedly reflected between this light outgoing surface and the reflective electrode 8, and is likely to be trapped inside the organic EL device B. Therefore, as the visual field angle increases, the amount of the outgoing light decreases. In contrast to this, among the lights emitted from the organic light emitting layer 12 of the organic EL device C according to Embodiment 1, even when the light entering the light outgoing surface 9a of the transparent substrate 9 at the critical angle or larger is totally reflected by the light outgoing surface 9a, the angle to the light outgoing surface 9a varies when the light is reflected by the reflective electrode 13 having a curved shape as mentioned above, thus facilitating the light to outgo from the organic EL device C. Therefore, it is conceivable that the overall luminance increases, and that the amount of the light outgoing toward an oblique direction increases in particular.

In addition, it is found that in the organic EL device C, the luminance in a specific direction (about 50° with respect to the normal direction of the light outgoing surface) increases. It should be noted that this specific direction can be changed by appropriately designing the shape and the distribution of the irregularities.

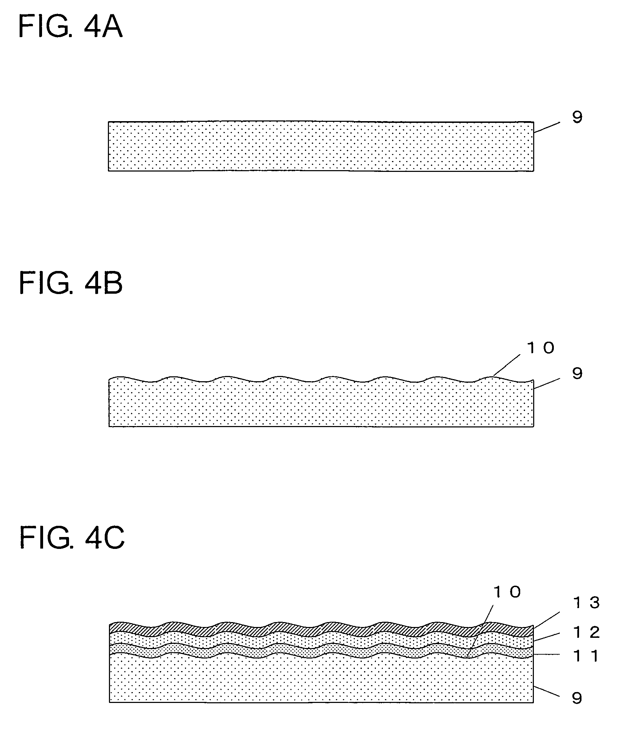

Next, a description will be given to a method of manufacturing the organic EL device C described above. As shown in Fig. 4A, the planer transparent substrate 9 is prepared. On the surface of this transparent substrate 9, a patterning is conducted by photoresist or the like with a mask having a pattern corresponding to the arrangement of a concave portion and a convex portion to be formed by etching, the irregularity surface 10 as shown in Fig. 4B is formed by carrying out the etching in this state.

Then, as shown in Fig. 4C, sequentially in a uniform thickness, the transparent electrode 11 is formed on the irregularity surface 10 of transparent substrate 9, the organic light emitting layer 12 is formed on the transparent electrode 11, and further the reflective electrode 13 is formed on the organic light emitting layer 12. The transparent electrode 11, the organic light emitting layer 12, and the reflective electrode 13 are respectively so formed as to have irregularities on the surface thereof which is in contact with the layer on the transparent substrate 9 side. Each layer is formed in a uniform thickness, and therefore has a curved shape conforming to the irregularity surface 10 of the transparent substrate 9. In this way, the organic EL device C shown in Fig. 1 is manufactured.

It should be noted that the irregularity surface 10 of the transparent substrate 9 can also be formed by surface processing under sandblast or by pouring melt transparent resin, glass, or the like into a mold having an irregularly shaped inner surface instead of etching.

Further, a known material and forming method can be employed as the material for each of layers and the methods of forming the respective layers, and so forth, in the liquid crystal panel A and the organic EL device C. For example, the transparent substrate 9 of the organic EL device C may be formed by a transparent or translucent material to the visible light such as glass or resin meeting such conditions. It suffices that the transparent electrode 11 has a function of an electrode and is transparent or translucent to the visible light, for instance, ITO is adopted for its material. The material for the organic light emitting layer 12 contains at least a known organic light emitting material such as Alq₃ or DCM. In addition, one or plural layers such as an electron transport layer and a hole transport layer adopted in a known organic EL device may be formed between the electrodes arbitrarily, and each layer may be appropriately formed of a known material. It suffices that the reflective electrode 13 has a function of an electrode and is reflective to the visible light, for example, Al, Cr, Mo, an Al alloy, an Al/Mo laminate, or the like can be adopted. The respective layers may be formed by a known thin film formation method such as a vacuum evaporation method.

### Embodiment 2

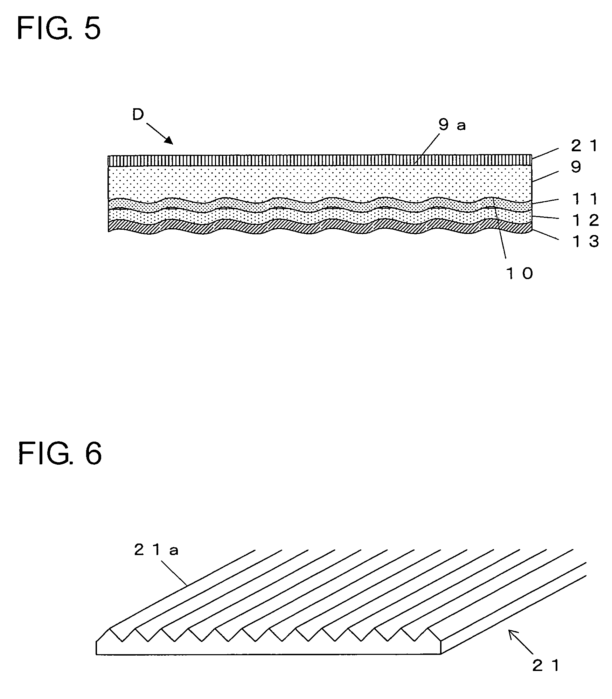

Fig. 5 shows a cross section of an organic EL device D according to Embodiment 2. The organic EL device D of Embodiment 2 is obtained by arranging one prism sheet 21 on the light outgoing surface 9a of the transparent substrate 9 of the organic EL device C in Embodiment 1. The prism sheet 21 herein has a plurality of linear convex portions 21a formed in parallel to each other as shown in Fig. 6. Each of the linear convex portions 21a is sharply pointed to have a triangular shape in cross section. This prism sheet 21 is arranged on the light outgoing surface 9a of the transparent substrate 9, therefore the direction of light emitted from the light outgoing surface 9a is refracted according to the shape of the linear convex portions 21a (the angle with respect to the light outgoing surface 9a having a triangular shape in cross section), and the refractive index of the prism sheet 21. For instance, when a prism sheet for refracting the light having an incident angle of about 50° in the normal direction of the light outgoing surface 9a is used, it is possible to provide the organic EL device having the outgoing characteristics shown in Fig. 3 with higher luminance in the normal direction of the light outgoing surface 9a than that of other directions.

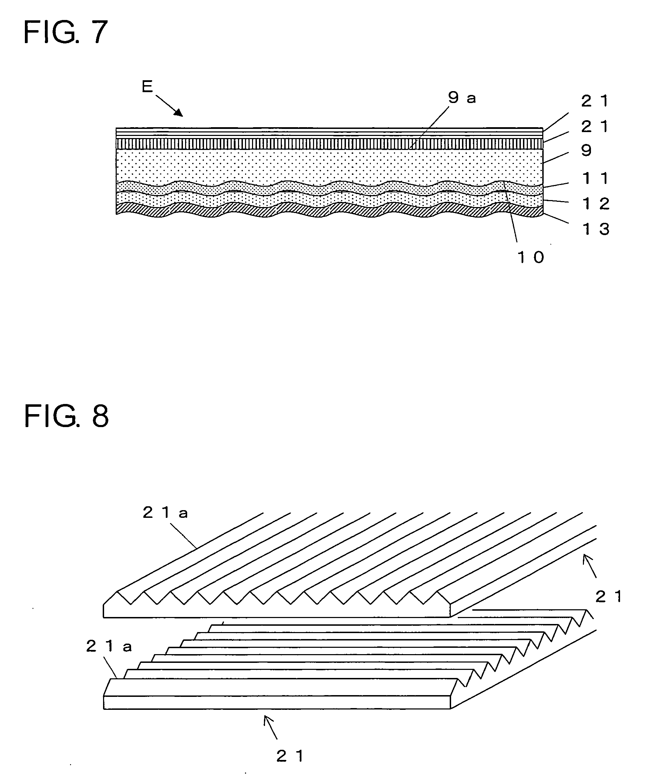

In addition, as in an organic EL device E shown in Fig. 7, two prism sheets 21 may be laminated and disposed on the light outgoing surface 9a of the transparent substrate 9. In that case, the two prism sheets 21 are disposed so that the extending directions of the linear convex portions 21a intersect each other as shown in Fig. 8. With this configuration, larger amount of light can be made into light traveling in the normal direction of the light outgoing surface 9a.

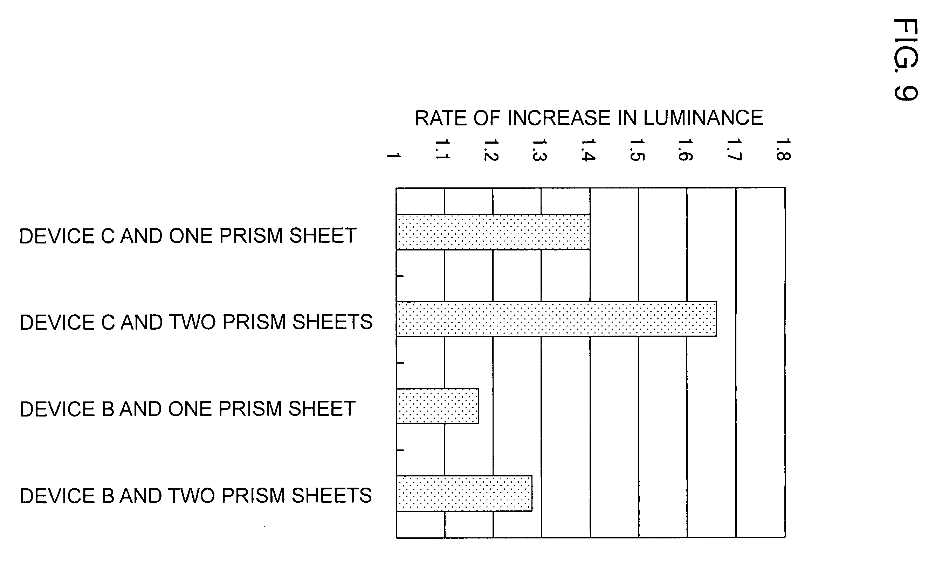

Now, measurement for the rate of increase in frontal luminance was conducted on the organic EL device D (the organic EL device C and one prism sheet) and the organic EL device E (the organic EL device C and two prism sheets) in Embodiment 2 with respect to that of the organic EL device C, and was conducted on devices obtained by respectively providing on the light outgoing surface of the transparent substrate 5 of the conventional organic EL device B shown in Fig. 13 with one prism sheet 21 (the organic EL device B and one prism sheet) and two prism sheets 21 (the organic EL device B and two prism sheets) with respect to that of the organic EL device B. Results shown in Fig. 9 were obtained.

The rate of increase in luminance was 1.17 times when the conventional organic EL device B was provided with the one prism sheet 21 and 1.28 times when the conventional organic EL device B was provided with the two prism sheets 21. In contrast to this, the rate of increase in luminance was 1.4 times when the organic EL device C was provided with the one prism sheet 21 (the organic EL device D) and 1. 66 times when the organic EL device C was provided with the two prism sheets (the organic EL device E). To summarize, the organic EL device C has the larger rate of increase in frontal luminance than the conventional organic EL device B due to the provision of the prism sheet 21. The reason for this is probably as follows. As described above, the amount of light outgoing in an oblique direction in the organic EL device C is increased more than that in the conventional organic EL device B, and this light which outgoes in an oblique direction is condensed by the linear convex portions 21a of the prism sheet 21. As a result, the amount of light from the light outgoing surface in a perpendicular direction increases. In addition, in both cases of the organic EL device B and the organic EL device C, providing the two prism sheets 21 makes the rate of increase in frontal luminance larger than providing the one prism sheet 21. This is because of the following reason. As shown in Fig. 6, in the prism sheets 21 having the plural linear convex portions 21a formed in parallel to each other, the condensing function is effected only in the width direction of the respective linear convex portions 21a. Therefore, by arranging the two prism sheets 21 so that the extending directions of the linear convex portions 21a intersect each other, the condensing function is effected in the width direction of the respective linear convex portions 21a of the two prism sheets 21, and as a result, the rate of increase in frontal luminance in this case is larger than that in the case of using the one prism sheet 21.

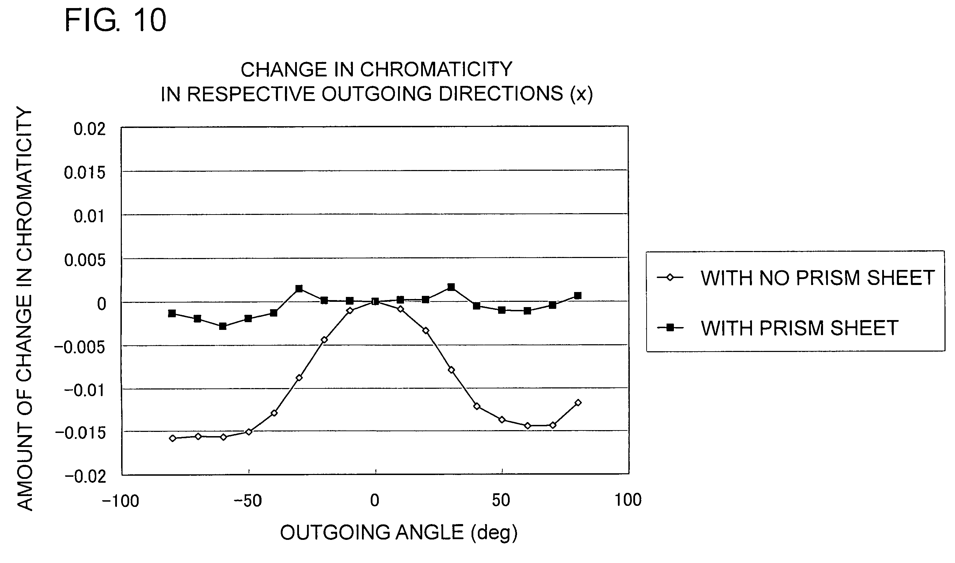

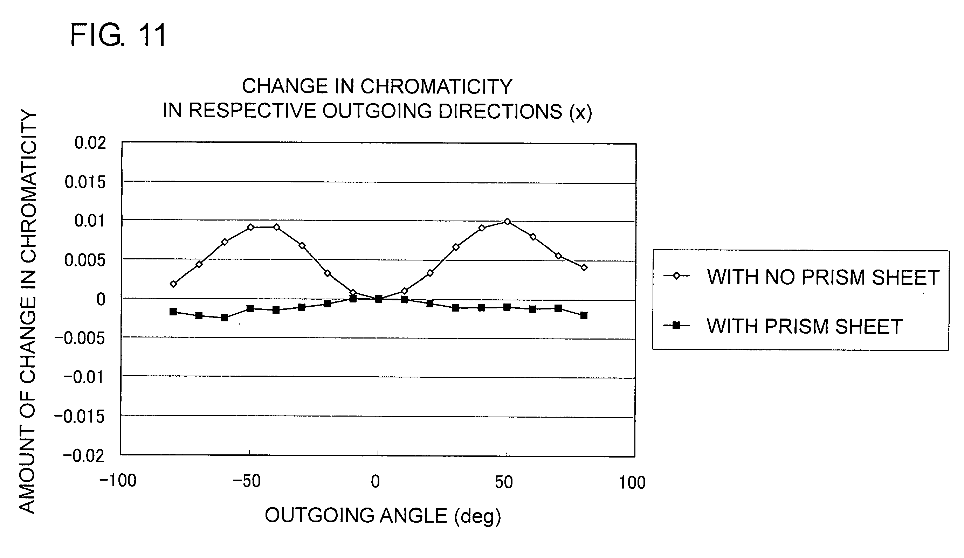

Then, measurement was conducted on the case of disposing no prism sheets 21 (the organic EL device C) and the case of disposing the prism sheet 21 on the light outgoing surface 9a of the organic EL device C (the organic EL device D) for the change in chromaticity coordinates x and y in the respective outgoing directions with the normal of the light outgoing surface 9a as the reference. The results shown in Fig. 10 and Fig. 11 were obtained.

Those results show that even in the case of disposing no prism sheets 21 (the organic EL device C), the amount of change in chromaticity coordinates x and y in the respective outgoing directions is sufficiently small, and the chromaticity characteristics are improved as compared to those of the conventional organic EL device. The reason why the chromaticity characteristics are improved in this way is probably that the organic EL device C has irregularity surface and thus takes out a larger amount of light having a wavelength with a small critical angle as compared with the conventional organic EL device.

In addition, it was found that when the prism sheet 21 was disposed on the light outgoing surface 9a of the organic EL device C (the organic EL device D), the amount of change in chromaticity coordinates x and y in the respective outgoing directions was still smaller, therefore making it possible to achieve further uniform chromaticity. When two prism sheets 21 are laminated and disposed while intersecting each other, the light with still more uniform color will be obtained.

In this way, the organic EL device D and the organic EL device E have the improved chromaticity characteristics as compared to the conventional device. Further, by disposing one or two of prism sheets on the light outgoing surface 9a of the transparent substrate 9 in the organic EL device C, the light outgoing from the organic EL device C in an oblique direction is utilized to achieve the uniform chromaticity as well as the enhancement in frontal luminance.

Note that, each of the organic EL device D and the organic EL device E according to Embodiment 2 can be used for the backlight of the liquid crystal display device similarly to the organic EL device C according to Embodiment 1.

It is also possible to use various types of prism sheets such as a prism sheet having convex portions or v-shaped grooves formed in lattice on its surface and a prism sheet having convex portions formed concentrically thereon instead of the prism sheets 21 (luminance enhancement films) having the linear convex portions 21a formed parallel to each other.

Note that in Embodiments 1 and 2 described above, although a concave portion and a convex portion are formed at random on the irregularity surface 10 of the transparent substrate 9, an irregularity surface having a plurality of concave portions and convex portions formed with regularity thereon may be used. However, the random irregularity surface 10 allows the transparent electrode 11 and the reflective electrode 13 to have random irregularities formed thereon. As a result, the refracted lights through the transparent electrode 11 and the reflected lights by the reflective electrode 13 travel in various directions, thereby attaining still higher diffusion effect. Also, when the random irregularities are provided, the probability of taking out the lights traveling in diverse directions from the organic light emitting layer 12 becomes higher.

Further although in Fig. 1, plural concave portions and convex portions are alternatively and continuously formed over the entire surface of the transparent substrate 9, the irregularities may be formed on a part of the surface of the transparent substrate 9. With this configuration, each of the transparent electrode 11, the organic light emitting layer 12, and the reflective electrode 13 has the irregularities on a part of its surface, and the similar effect such as the diffusion effect described above can be obtained. Moreover, instead of a plurality of irregularities, only one irregularity, that is, one concave portion and one convex portion may be formed thereon. In addition, even when a concave portion alone or a convex portion alone is formed on the surface of the planer transparent substrate 9, and the transparent electrode 11, the organic light emitting layer 12, and the reflective electrode 13 are sequentially formed over this surface, it is possible to attain the similar effect such as the diffusion effect described above.

Herein, as shown in Fig. 12, among the lights emitted from a concave portion 12a of the organic light emitting layer 12 having a curved shape, a main part of a light L5 emitted toward the transparent electrode 11 direction passes through the transparent electrode 11 and the transparent substrate 9 to outgo from the light outgoing surface, and a light L6 emitted toward the reflective electrode 13 direction is reflected by the reflective electrode 13, and thereafter passes through the transparent electrode 11 and the transparent substrate 9 to outgo from the light outgoing surface. Further, a light L7 emitted in parallel to the light outgoing surface of the transparent substrate 9 from the concave portion 12a of the organic light emitting layer 12 is also reflected by the reflective electrode 13 and passes through the transparent electrode 11 and the transparent substrate 9 to outgo from the light outgoing surface.

In contrast to this, a convex portion 12b of the organic light emitting layer 12 is positioned so that its boundary surface with the transparent electrode 11 is covered. Therefore, even if light emission from the convex portion 12b is caused, as compared to the case of the light emission from the concave portion 12a, the amount of light reflected by its boundary surface with the transparent electrode 11 and trapped inside the organic light emitting layer 12 increases. In other words, it is difficult to efficiently take out the light emitted from the convex portion 12b of the organic light emitting layer 12, which is elevated with respect to the light outgoing surface.

Thus, when the area occupied by the concave portion where the light taking-out efficiency is high is set large with respect to the entire surface of the organic light emitting layer 12, the improvement of light taking-out efficiency is achieved in overall. In this manner, it is preferred to form such an irregularity surface 10 in which the occupying area of the concave portion of the organic light emitting layer 12 is large on the surface of the transparent substrate 9. It becomes also possible to set the luminance in a certain direction high depending on the condensing characteristics of the concave portion.

Similarly, by adjusting the shape, number, size, distance, etc., of the irregularities formed on the surface of the transparent substrate 9, the degree of the diffusion effect and the light taking-out efficiency can be changed.

Further, although in Embodiments 1 and 2 each layer of the transparent electrode 11, the organic light emitting layer 12, and the reflective electrode 13 formed on the irregularity surface 10 of the transparent substrate 9 has the irregularities, when at least one layer of the respective layers has irregularities, the light can be diffused at the boundary of the layer. In this regard, if irregularities are formed on the reflective electrode 13, a larger diffusion effect can be attained because the lights are diffused and reflected by the reflective electrode 13 to be refracted by a boundary of other layers in various directions.

Also in above-mentioned Embodiments 1 and 2, each of the transparent electrode 11, the organic light emitting layer 12, and the reflective electrode 13 is formed to have a shape having a uniform thickness and substantially parallel to the irregularity surface 10 of the transparent substrate 9. However, instead of providing each of the layers with shapes similar to each other, an arbitrary layer may have a shape in which a concave portion is formed thicker than a convex portion or a shape in which a convex portion is formed thicker than a concave portion. With such configuration, the respective layers have the shapes different from each other and have different refraction directions by the boundaries, resulting in the improvement in diffusion effect.

Described in Embodiments 1 and 2 is the organic EL device of a bottom emission type where the transparent electrode 11, the organic light emitting layer 12, and the reflective electrode 13 are sequentially layered on the transparent substrate 9 and the light emitted from the organic light emitting layer 12 passes through the transparent electrode 11 and the transparent substrate 9 to outgo. The present invention, however, is not limited to this but is applicable to an organic EL device of a top emission type where a reflective electrode, an organic light emitting layer, and a transparent electrode are sequentially layered on a substrate and the light emitted from the organic light emitting layer passes through the transparent electrode opposite to the substrate to outgo. In this top emission type, the reflective electrode and the transparent electrode function as the first electrode layer and the second electrode layer of the present invention, respectively, and it does not matter whether or not the substrate is transparent to the visible light. Also, a surface of the transparent electrode opposite to the surface thereof in contact with the organic light emitting layer serves as the light outgoing surface. By disposing a prism sheet on this light outgoing surface, it is possible to enhance the frontal luminance as in Embodiment 2 described above. It should be noted that at this time a configuration may be taken in which a protective film made of an oxide film, a nitride film, or the like is formed on the light outgoing surface, and a prism sheet is formed on this protective film.

While the organic EL device has been described above, the present invention can be applied to an inorganic EL device in a similar manner.

As described above, according to the present invention, it is possible to provide the EL device capable of avoiding the light attenuation due to the use of the diffusion plate and diffusing the light sufficiently to conduct the uniform illumination while having a simple structure.

According to the present invention, it is possible to provide the EL device which attains a large light emission amount.

According to the present invention, it is possible to provide the EL device which attains high light taking-out efficiency.

According to the present invention, it is possible to provide the EL device which attains high luminance in a certain direction.

According to the present invention, it is possible to provide the EL device in which a difference in chromaticity depending on the outgoing directions is small.

According to the present invention, it is possible to provide a manufacturing method with which such an EL device can be obtained and the liquid crystal display device using such an EL device.

## Claims

1. An EL device, comprising:
a substrate;
a first electrode layer formed on a surface of the substrate;
a light emitting layer formed on the first electrode layer; and
a second electrode layer formed on the light emitting layer,
the surface of the substrate having irregularities formed thereon, at least one of the layers formed on the surface of the substrate having irregularities formed on a surface thereof which is in contact with the layer on a side of the substrate.

2. An EL device according to claim 1, wherein the at least one of the layers is formed in a substantially uniform thickness.

3. An EL device according to claim 1, wherein the at least one of the layers has a curved shape conforming to the surface of the substrate on which the irregularities are formed.

4. An EL device according to claim 1, wherein the light emitting layer has a curved shape conforming to the surface of the substrate on which the irregularities are formed.

5. An EL device according to claim 1, wherein one of the first electrode layer and the second electrode layer opposite to a light taking-out side with respect to the light emitting layer is formed of a reflective electrode and the other is formed of a transparent electrode, and the reflective electrode has a curved shape conforming to the surface of the substrate on which the irregularities are formed.

6. An EL device according to claim 1, wherein the surface of the substrate on which the irregularities are formed is an irregularity surface on which a concave portion and a convex portion are formed at random.

7. An EL device according to claim 1, further comprising at least one prism sheet disposed on a light taking-out side with respect to the light emitting layer.

8. An EL device according to claim 7, wherein the at least one prism sheet has a plurality of linear convex portions disposed in parallel to each other, each of the linear convex portions being sharply pointed to have a triangular shape in cross section.

9. An EL device according to claim 8, wherein two prism sheets are overlapped and disposed so that extending directions of the linear convex portions intersect each other.

10. A method of manufacturing an EL device, comprising:
forming irregularities on a surface of a substrate;
forming a first electrode layer on the surface of the substrate;
forming a light emitting layer on a surface of the first electrode layer; and
forming a second electrode layer on a surface of the light emitting layer,
at least one of the layers formed on the surface of the substrate having irregularities formed on a surface thereof which is in contact with the layer on a side of the substrate.

11. A method of manufacturing an EL device according to claim 10, wherein one of the first electrode layer and the second electrode layer opposite to a light taking-out side with respect to the light emitting layer is formed of a reflective electrode and the other is formed of a transparent electrode, and the reflective electrode has a curved shape conforming to the surface of the substrate on which the irregularities are formed.

12. A method of manufacturing an EL device according to claim 10, wherein the at least one of the layers includes the light emitting layer.

13. A liquid crystal display device comprising the EL device according to claim 1 used for a backlight.
